Europäisches Patentamt

European Patent Office

Office européen des brevets

(11) Publication number: **0 063 309**
**B1**

(12) **EUROPEAN PATENT SPECIFICATION**

(45) Date of publication of patent specification: **27.11.85**

(21) Application number: **82102925.3**

(22) Date of filing: **06.04.82**

(51) Int. Cl.⁴: **H 01 S 3/23**, B 23 K 26/02

(54) **Laser apparatus.**

(30) Priority: **09.04.81 JP 54706/81**
**25.01.82 JP 10556/82**

(43) Date of publication of application:
**27.10.82 Bulletin 82/43**

(45) Publication of the grant of the patent:
**27.11.85 Bulletin 85/48**

(84) Designated Contracting States:
**DE FR GB**

(56) References cited:
**FR-A-1 500 039**
**FR-A-2 197 614**
**US-A-3 431 513**

(73) Proprietor: **FUJITSU LIMITED**
**1015, Kamikodanaka Nakahara-ku**
**Kawasaki-shi Kanagawa 211 (JP)**

(72) Inventor: **Hirokazu, Fukuda**
**2-7, Matsunouchi 1-chome**
**Akashi-shi Hyogo, 673 (JP)**
Inventor: **Koji, Shinohara**
**6-28, Suganodai 4-chome**
**Suma-Ku Kobe-shi Hyogo, 654 (JP)**
Inventor: **Yoshio, Kawabata**
**2574-13, Kasugano-cho**
**Takasago-shi Hyogo, 676 (JP)**
Inventor: **Yoshito, Nishijima**
**4-32, Seiryodai 3-chome**
**Tarumi-ku Kobe-shi Hyogo, 655 (JP)**
Inventor: **Kosaku, Yamamoto**
**10-20, Tamondai 1-chome**
**Tarumi-ku Kobe-shi, Hyogo, 655 (JP)**

(74) Representative: **Reinländer & Bernhardt**
**Patentanwälte**
**Orthstrasse 12**
**D-8000 München 60 (DE)**

Courier Press, Leamington Spa, England.

EP 0 063 309 B1

## Description

Background of the Invention
*Field of the Invention*
The invention of this application relates to an improvement in a semiconductor laser apparatus which radiates invisible light, more specifically it relates to an infrared ray diode laser apparatus which has a simplified adjustment of the optical axis.

*Description of the Prior Art*
Recently, an atmospheric gas monitor system and a gas leak monitor system utilizing infrared rays have been widely put into practical use. These systems utilize the principle of infrared absorption spectrometry. Basically, the optical path for measurement is set between the infrared light source and the infrared light detector, and a contamination on the leak source gas is defined from the absorption amount of infrared light. However, in the case of constituting a system for monitoring the gas condition in the long-path as long as several hundred meters on the real time basis by using the laser as the infrared light source and setting an indoor optical path for measurement, it becomes a large problem how to adjust the emitting axis of the invisible infrared laser to the optical axis of the detector.

Presently, it is well known to superimpose the visible laser beam on the infrared laser beam on the occasion of adjusting the optical axis of the infrared laser source in the long-path infrared gas detection system (see, e.g. FR—A—1500039). In the case of this optical axis adjustment method, for example, as disclosed in the Japanese examined patent publication Toku-Ko-Sho No. 52—41113, the optical axis of the visible laser beam is superimposed on the axis of the infrared laser beam and thereafter the optical axis of the system as a whole is adjusted using the visible laser beam. However, such a superimposing operation of the optical axis is very difficult for the existing technology, because the He—Ne gas laser is used independently of the infrared laser as the visible laser source, and moreover there has been a problem that the detection of superimposed axes has required a great skill.

Summary of the Invention
This invention is mainly intended, considering such present conditions, to make easier the adjustment of the optical axes of an invisible laser operating in the infrared or ultraviolet region.

This invention is also intended to provide a laser apparatus providing a simplified optical axis adjusting means for the semi-conductor laser element which is used as the infrared laser source particularly in a long-path gas monitor system.

This invention is further intended to provide a laser apparatus which can easily re-adjust the optical axes for the replacement or repair of laser elements.

Briefly, an embodiment of this invention is characterized by the structure of a laser apparatus, where a visible light emitting element having the light emitting surface in the same direction is mounted on a common supporting member adjacent to an invisible semiconductor laser element. Moreover, the embodiment is characterized by such an optical axis adjusting means, where a visible light emitting element is mounted on a common stem adjacent to an invisble semiconductor laser element and the preadjusted relative positional relation between the visible light emitting element and a light issuing collimator is replaced by the relative positional relation between the invisible semiconductor laser element and the light issuing collimator system. Namely, after the optical axis of the laser apparatus is adjusted using the visible light of the visible light emitting element, the light source position is replaced by moving the laser mount as much as the interval between the visible and the invisible light emitting elements. Thereby, the invisible laser axis can be aligned automatically.

Brief Description of the Drawings
Fig. 1 is a perspective view indicating an embodiment of the laser apparatus of the present invention.
Fig. 2A and Fig. 2B explain the principle of the light axis adjustment of the present invention.
Fig. 3 shows a partial sectional view indicating an embodiment of the infrared laser source unit adopting the present invention.

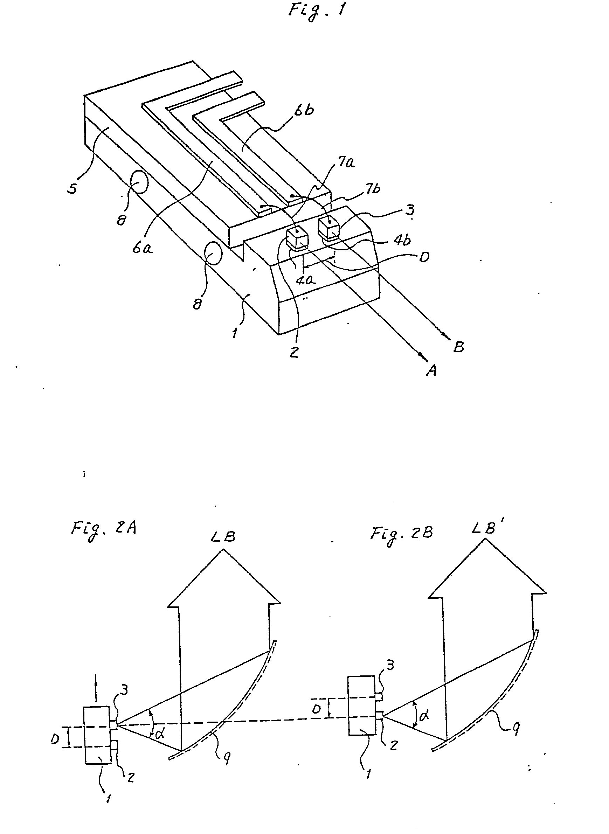

Description of the Preferred Embodiments
Fig. 1 is a perspective view of an embodiment of the semiconductor laser mount structure of the present invention. The infrared ray semi-conductor laser element 2 and the visible semi-conductor laser element 3 are adjacently fixed using respectively the indium layer (In) 4a, 4b, at the top of the cooling stem 1 made of copper (Cu) as the supporting member. In addition, the ceramic plate 5 is placed at the upper part of the stem and a couple of lines of terminal lead conductors 6a and 6b are provided thereon. These conductors are connected to the top contacts of the couple of laser elements 2 and 3 with the gold (Au) lines 7a, 7b. Moreover, this cooling stem 1 is provided with the screwing holes 8, through which the pertinent laser mount is attached to the cooling unit.

Here, the infrared laser element 2 is a well known diode laser in the size of about 200 μm × 200 μm × 200 μm made of a lead-chalcogenide multi-element semiconductor such as PbSnTe or PbSSe and is mounted so that the light emitting surface is oriented to the direction indicated by the arrow mark A. In addition, the visible laser element 3 is a red diode laser made of GaAlAs material and is mounted so that the light emitting surface is oriented to the direction indicated by the arrow mark B which is parallel with the infrared ray emitting direction. Since the visible diode laser element 3 is generally operated under room temperature, it is usually mounted on the stem using AuGe or AuSn. But, in the case of this invention, when considering that the visible laser element is operated together with the infrared diode laser element 2 under the condition cooled to a low temperature, such a mounting structure is weak for the thermal cycle and is not practical. For this reason, in the present invention, as in the case of the infrared diode laser 2, the visible diode laser element 3 is recommended to be bonded with the soft In layer 4 which is capable of absorbing thermal contraction.

Such a semiconductor laser assembly causes both the semiconductor laser elements 2, 3 to emit the light by setting it in a Dewar etc. and placing it under the condition cooled up to 77°K by means of liquid nitrogen and applying a drive current to it via the lead conductors 6a, 6b.

In such a condition, both the semiconductor laser elements emit the light. Namely, the element 2 emits the invisible infrared laser beam having the wavelength of 4 to 20 µm, while the element 3 emits the visible laser beam having the wavelength of 0,7 µm in parallel with the invisible beam. Therefore, the optical axis of the infrared ray emitted from the laser element 2 is coarsely set depending on the visible beam emitted from the laser element 3, while the drive current to the infrared laser element is being cut. Thereafter, the emission of the visible laser beam is stopped by a method such as ceasing the supply of the drive current to the visible laser element 3, the infrared laser element 2 is operated and the optical axis of the infrared laser beam emitted from the laser element is adjusted precisely. Thereby the optical axis can be adjusted simply and quickly, saving the procedure for finding the path of the infrared laser beam in the space.

Meanwhile, as one of the characteristics of the semiconductor diode laser, the beam emitted from the laser element has a comparatively wide light emitting angle, for example, about 30°. Thus, it is essential to combine the collimator system which converges the radiated laser beam to the parallel beam for the use of such a laser beam emitted from such a semiconductor laser element. On the one hand, this invention utilizes the characteristic of such an optical system and therefore a little deviation of the emitting directions of the two infrared and visible laser elements may be allowed. But, since the optical position for the optical system is an important factor for determining the accuracy of adjustment in the optical axis, the interval dimension D between the two laser elements 2 and 3 must be known beforehand. The actual interval dimension D can be set within the range from 500 to 1000 µm.

Fig. 2 schematically shows the principle of the optical axis adjustment of the present invention. As shown in Fig. 2A, the positional relation between the visible semiconductor laser 3 and the paraboloid mirror 9 as the light emitting collimator system is adjusted and the parallel laser beam LB reflected from the paraboloid mirror 9 is adjusted to the predetermined optical axis. Such an adjustment of the optical axis is not difficult, because the laser beam LB is the visible light. In fact, the read diode laser of the GaAlAs family currently used has an optical output power of about 10 mW and the converged optical beam can transmit sufficiently between long-path measuring systems of about several hundred meters.

Thereafter, the positional relation as shown in Fig. 2B is obtained by moving the common stem 1 by the distance corresponding to the interval D of the two laser elements 2 and 3 in the element arranging direction. Thereby, the light source of the paraboloid mirror 9 has been replaced from the visible laser element 3 to the infrared laser element 2 and the infrared laser beam LB' is emitted from the paraboloid mirror 9 in the same optical axis. In this case, as explained previously, since the laser beam emitted from a semiconductor laser element has a comparatively wider emission angle, the infrared laser beam LB' can be obtained on the same optical axis adjusted using the visible laser beam, so long as the paraboloid mirror 9 exists within the range of the emission angle α of the infrared laser element 2 replaced for the visible laser element 3. Therefore, the parallelism between the laser beam emitting directions A, B of the two laser elements 2 and 3 is not a so serious problem.

The light emission collimator for obtaining the parallel beam can also be formed using the collimator lens, in place of the paraboloid mirror 9. Moreover, it is also possible to align the optical axis by shifting the paraboloid mirror or the collimator lens, in place of replacing the light source by shifting the laser mount. Namely, after adjusting the optical axis using the visible laser beam, the collimator system is shifted in parallel as much as the interval D of the two laser elements. Thereby, the optical axis is shifted in parallel as much as the dimension D for the infrared laser beam 2. However, in the long-path gas monitor system where the reciprocal optical path is set using the retro-reflector, it is better to employ the system where the laser mount side is shifted, which does not required the readjustment of the retro-reflector and detector.

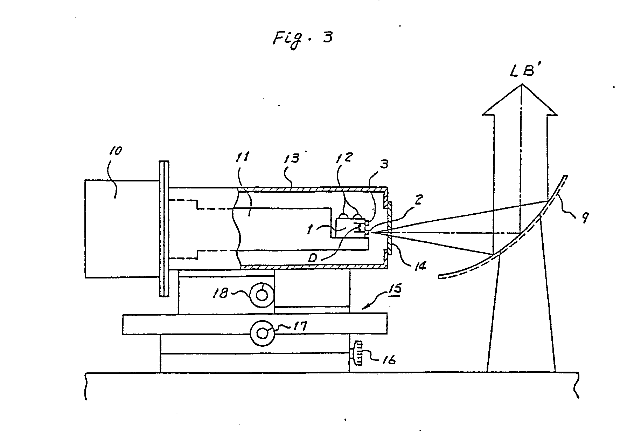

Fig. 3 shows a section view of the structure of the infrared laser beam source unit adopting this invention.

The cooling rod 11 is provided in coupling with the helium (He) refrigerator 10, and the cooling stem 1 of the laser mount explained precedingly is fixed with the screw 12 at the heading portion of the cooling rod. The cooling rod 11 is placed under the hermetically sealed ambient defined by the vacuum envelope 13 in order to obtain the adiabatic effect, and the transparent window 14 for the infrared beam and the visible beam is provided in such an area opposing to the semiconductor laser elements 2, 3. Here, $BaF_2$, $CaF_2$ or Irtran is adequate as the material for the window 14 which is transparent for both the infrared and the visible beam.

The refrigerator cooling type semiconductor laser system is supported as a whole on the fine adjusting mechanism 15. This fine adjusting mechanism 15 includes the X axis adjusting dial 16 in relation with the X stage, the Y axis adjusting dial 17 in relation with the Y axis and the height adjusting dial 18 in relation with the elevating stage. This embodiment shown in Fig. 3 provides a couple of infrared and visible laser elements 2, 3 arranged with the interval D in the height direction and requires only the adjustment of the dial 18 of the height adjusting micrometer in order to set the optical axis of the infrared beam. Namely, when the laser system as a whole is elevated only by the dimension D using the height adjusting micrometer 18, after the optical axis is adjusted using the visible laser element 3, the light source for the paraboloid mirror 9 as the collimator is replaced to the infrared laser element 2 and the infrared laser beam LB' can be emitted on the same optical axis.

In the above example, a couple of infrared and visible semiconductor laser elements are mounted and it is also possible to mount two or more infrared laser elements which provide the same or a different oscillation wavelength. In addition, the lead-chalcogenide infrared diode laser element can also be cooled up to the operating temperature by being mounted in a vacuum Dewar and using liquid nitrogen ($N_2$) or liquid helium (He). In this case, the vacuum Dewar is mounted on the fine adjusting mechanism and the optical axis is adjusted as in the case mentioned above. As a visible laser beam emitting element, a light emitting diode (LED) may be used in place of a semiconductor laser element. The LED has a wider light emission angle, but it offers a sufficiently focused visible light beam through the combination of light condensing systems.

As is apparent from the above explanation, the present invention is essentially intended, in summary, to mount the visible light emitting element on the common supporting member adjacent to the invisible (infrared or ultraviolet) semiconductor laser element and to perform the setting of the optical axis of the infrared laser beam using the visible light beam.

Consequently, this invention results in the advantage that the adjustment is very simplified and becomes reliable as compared with the existing method of superimposing the optical axes. Information about the interval distance between the visible and invisible laser elements easily allows the readjustment of the optical axis using the visible laser beam, even if the laser mount is replaced. Resulting, this invention is very effective for the simplification of the optical axis adjustment when it is adopted in the long-path gas detection system utilizing infrared rays.

## Claims

1. A laser apparatus having cooing means, a cooling stem as a supporting member coupled to said cooling means and an infrared laser element consisting of a lead-chalcogenide semiconductor mounted on said cooling stem and emitting an infrared beam, said laser apparatus comprising a visible light-emitting semiconductor element (3) mounted on said cooling stem (1) spaced from said infrared laser element (2) by a predetermined distance (D) and emitting a visible light beam (B) in parallel with and in the same direction as the infrared beam (A) emitted by said infrared laser element.

2. A laser apparatus claimed in claim 1, wherein the infrared laser element (2) and the visible light-emitting semiconductor laser element (3) are fixed with indium (In) (4) on the common cooling stem (1).

3. A laser apparatus claimed in claim 2, wherein the cooling stem (1) as the supporting member is mounted at the top end of a cooling rod (11) surrounded by a vacuum envelope (13) and the cooling rod is coupled with a refrigerator unit (10).

4. A laser apparatus claimed in claim 3, wherein a light transmitting window (14) which allows the infrared rays emitted from the infrared diode laser element (2) and the visible light emitted from the visible light-emitting semiconductor laser element (3) to pass is provided in the area opposing to the cooling stem (1) of the vacuum envelope (13).

5. A laser apparatus comprising an invisible light-emitting semiconductor laser element (2) mounted on a supporting member and a light converting optical system (9) which converts the invisible laser beam (9) emitted from the laser element into a parallel beam (LB), wherein a visible light-emitting element (3) is mounted on the same supporting member (1) adjacent to the invisible light-emitting semiconductor laser element and at a predetermined distance (D) from the invisible light-emitting semiconductor laser element whereby in use the visible and invisible laser beams emitted by the respective semiconductor laser elements are mutually parallel and in the same direction, and a position adjusting means (15) for adjusting the position of the invisible light-emitting semiconductor laser element relative to the light converting optical system, the position adjusting means being coupled to at least one of the supporting members and the light converting optical system.

6. A laser apparatus claimed in claim 5, wherein the position adjusting means (15) comprises a position adjusting micrometer (18) which shifts the invisible light-emitting semiconductor laser element (2) to the position of the visible light emitting element (3) preadjusted for the light converting optical system (9) by shifting the supporting member (1) mounting in common the laser elements as much as the interval distance between the invisible light-emitting semiconductor laser element and the visible light-emitting element.

7. A laser apparatus claimed in claim 5, wherein the invisible light-emitting semiconductor laser element (2) is composed of a lead-chalcogenide infrared diode laser mounted on a cooling stem (1) as the supporting member placed in a vacuum envelope (13) and the visible light-emitting element (3) is mounted on the common cooling stem adjacent to the invisible light-emitting semi-conductor laser element, thus both the elements can be cooled to a low temperature.

## Revendications

1. Appareil laser ayant un dispositif de refroidissement, un montant de refroidissement constituant un organe de support couplé au dispositif de refroidissement et un élément laser infrarouge formé d'un semi-conducteur d'un composé du plomb et d'un élément choisi dans le groupe qui comprend O, S, Se et Te, monté sur le montant de refroidissement et émettant un faisceau infrarouge, l'appareil laser comprenant un élément photoémissif visible à semi-conducteur (3) monté sur le montant de refroidissement (1) à une distance prédéterminée (D) de l'élément laser infrarouge (2) et émettant un faisceau lumineux visible (B) parallèlement au faisceau infrarouge (A) émis par l'élément laser infrarouge et dans la même direction.

2. Appareil laser selon la revendication 1, dans lequel l'élément laser infrarouge (2) et l'élément laser à semi-conducteur (3) émettant de la lumière visible sont fixés par de l'indium (In) (4) sur le montant commun de refroidissement (1).

3. Appareil laser selon la revendication 2, dans lequel le montant de refroidissement (1) constituant l'organe de support est monté à l'extrémité supérieure d'une tige de refroidissement (11) entourée par une enveloppe sous vide (13) et la tige de refroidissement est couplée à un ensemble réfrigérateur (10).

4. Appareil laser selon la revendication 3, dans lequel une fenêtre transparente à la lumière (14) qui permet le passage des rayons infrarouges émis par l'élément à diode laser infrarouge (2) et de la lumière visible émise par l'élément laser à semi-conducteur (3) émettant de la lumière visible, est placée dans la région disposée en face du montant de refroidissement (1) de l'enveloppe sous vide (13).

5. Appareil laser comprenant un élément laser à semiconducteur (2) émettant de la lumière invisible, monté sur un organe de support et un système optique (9) convertisseur de lumière qui transforme le faisceau laser invisible (9) émis par l'élément laser en un faisceau parallèle (LB), dans lequel un élément (3) émettant de la lumière visible est monté sur le même organe de support (1) près de l'élément laser à semi-conducteur émettant de la lumière invisible et à une distance prédéterminée (D) de l'élément laser à semi-conducteur émettant de la lumière invisible, si bien que, lors de l'utilisation, les faisceaux laser visible et invisible émis par les éléments laser respectifs à semi-conducteur sont parallèles l'un à l'autre et ont la même direction, et un dispositif de réglage de position (15) destiné à régler la position de l'élément laser à semi-conducteur émettant de la lumière invisible par rapport au système optique convertisseur de lumière, le dispositif de réglage de position étant couplé à au moins l'un des organes de support et du système optique convertisseur de lumière.

6. Appareil laser selon la revendication 5, dans lequel le dispositif de réglage de position (15) comporte un micromètre de réglage de position (18) qui déplace l'élément laser à semi-conducteur (2) émettant de la lumière invisible vers la position de l'élément émettant de la lumière visible (3) réglée préalablement pour le système optique (9) convertisseur de lumière par déplacement de l'organe de support (1) portant en commun les éléments laser, de la distance de l'intervalle compris entre l'élément laser à semi-conducteur émettant de la lumière invisible et l'élément émettant de la lumière visible.

7. Appareil laser selon la revendication 5, dans lequel l'élément laser à semi-conducteur (2) émettant de la lumière invisible est composé d'une diode laser infrarouge d'un composé du plomb et d'un élément choisi dans le groupe qui comprend O, S, Se et Te, monté sur un montant de refroidissement (1) constituant l'organe de support placé dans une enveloppe sous vide (13) et l'élément émettant de la lumière visible (3) est monté sur le montant commun de refroidissement près de l'élément laser à semi-conducteur émettant de la lumière invisible, les deux éléments pouvant ainsi être refroidis à une basse température.

## Patentansprüche

1. Laservorrichtung mit Kühleinrichtungen, mit einer Kühlhalterung als mit den Kühleinrichtungen gekuppelter Halteteil und mit einem Infrarotlaserelement, das aus einem Blei-Chalkogenid-Halbleiter besteht, der auf dem Halteteil angebracht ist, und einen Infrarotstrahl emittiert, wobei die Laservorrichtung ein sichtbares Licht emittierendes Halbleiterelement (3) enthält, das an der Kühlhalterung (1) in einem vorbestimmten Abstand (D) von dem Infrarotlaserelement (2) angeordnet ist und einen sichtbaren Lichtstrahl (B) parallel zu und in derselben Richtung wie der durch das Infrarotlaserelement emittierte Infrarotstrahl (A) emittiert.

2. Laservorrichtung nach Anspruch 1, bei der das Infrarotlaserelement (2) und das sichtbares Licht emittierende Halbleiterlaserelement (3) mit Indium (In) (4) auf der gemeinsamen Kühlhalterung (1) befestigt sind.

3. Laservorrichtung nach Anspruch 2, bei der die Kühlhalterung (1) als Halteteil am oberen Ende eines Kühlstabs (11) angebracht ist, der von einer Vakuumumhüllung (13) umgeben ist, und der Kühlstab mit einer Kühleinheit (10) gekuppelt ist.

4. Laservorrichtung nach Anspruch 3, bei der ein lichtdurchlässiges Fenster (14), das den Durchlaß der von dem Infrarot-Diodenlaserelement (2) emittierten Infrarotstrahlen und des von dem sichtbares Licht emittierenden Halbleiterlaserelement (3) emittierten sichtbaren Lichts erlaubt, in dem Bereich vorgesehen ist, welcher der Kühlhalterung (1) der Vakuumumhüllung (13) gegenüberliegt.

5. Laservorrichtung mit einem unsichtbares Licht emittierenden Halbleiterlaserelement (2), das an einem Halteteil angebracht ist, und mit einem lichtumwandelnden optischen System (9), das den von dem Laserelement emittierten unsichtbaren Laserstrahl (9) in einen parellelen Strahl (LB) umwandelt, wobei ein sichtbares Licht emittierendes Element (3) an demselben Halteteil (1) in der Nähe des unsichtbares Licht emittierenden Halbleiterlaserelements und in einem vorbestimmten Abstand (D) von dem unsichtbares Licht emittierenden Halbleiterlaserelement angebracht ist, wobei im Betrieb die sichtbaren und unsichtbaren Laserstrahlen, die von den jeweiligen Halbleiterlaserelementen emittiert werden, zueinander parallel und in derselben Richtung liegen, und mit einer Positionseinstelleinrichtung (15) zum Einstellen der Position des unsichtbares Licht emittierenden Halbleiterlaserelements relativ zu dem lichtumwandelnden optischen System, wobei die Positionseinstelleinrichtung mit wenigstens einem der Halteteile und dem lichtumwandelnden optischen System gekuppelt ist.

6. Laservorrichtung nach Anspruch 5, bei dem die Positionseinstelleinrichtung (15) ein Positionseinstellmikrometer (18) aufweist, welches das unsichtbares Licht emittierende Halbleiterlaserelement (2) zu der Stelle des sichtbares Licht emittierenden Elements (3) schiebt, das für das lichtumwandelnde optische System (9) voreingestellt ist, indem das Halteteil (1), das gemeinsam die Laserelemente befestigt, so viel wie der Abstand zwischen dem unsichtbares Licht emittierenden Halbleiterlaserelement und dem sichtbares Licht emittierenden Element verschoben wird.

7. Laservorrichtung nach Anspruch 5, bei der das unsichtbares Licht emittierende Halbleiterlaserelement (2) aus einem Blei-Chalkogenid-Infrarot-Diodenlaser besteht, der auf einer Kühlhalterung (1) als Halteteil angebracht ist, die in einer Vakuumumhüllung (13) angeordnet ist, und das sichtbares Licht emittierende Element (3) auf der gemeinsamen Kühlhalterung nahe dem unsichtbares Licht emittierenden Halbleiterlaserelement angebracht ist, womit beide Elemente auf eine niedrige Temperatur gekühlt werden können.

Fig. 1

Fig. 2A

Fig. 2B

Fig. 3